# EUROPEAN PATENT SPECIFICATION

(11) **EP 0 440 376 B1**
(45) Date of publication and mention of the grant of the patent: **24.04.1996**
(21) Application number: 91300564.1
(22) Date of filing: 24.01.1991
(51) Int. Cl.: G03F 7/039

(54) **Process for forming pattern**
Verfahren zur Herstellung einer Bildstruktur
Procédé de formation d'image

(30) Priority: 30.01.1990 JP 19531/90; 30.01.1990 JP 19530/90
(43) Date of publication of application: 07.08.1991
(73) Proprietor: MATSUSHITA ELECTRIC INDUSTRIAL CO., LTD., Kadoma-shi, Osaka-fu, 571 (JP)
(72) Inventor: Tani, Yoshiyuki, Neyagawa-shi (JP); Sasago, Masaru, Hirakata-shi (JP)
(74) Representative: Sorrell, Terence Gordon

(56) References cited:
- EP-A- 0 366 590
- US-A- 4 603 101

## Description

### BACKGROUND OF THE INVENTION

This invention relates to a process for forming pattern.

Recently, with the promotion of higher density integration of semiconductor devices, the light source wavelength of an exposure device used for fine process, especially photolithography is more and more shortened. At present i-line (365 nm) has entered its practical use and KrF excimer laser (248.4 nm) is already investigated. However, resist pattern materials, especially resist materials suitable for KrF excimer laser, and deep ultraviolet wavelength ranges have not been developed sufficiently. For example, even when MP2400 (Shipley Co.) which is said to have high sensitivity and transmittance for KrF excimer laser light is used, because of the surface absorption of a novolac resin which is a base polymer and poor optical reactivity of a sensitizer, a naphthoquinone diazide compound, pattern shape after pattern formation is too low in quality to be used.

Also as a pattern forming material for deep UV, there is reported a resist which contains 2-diazo-1,3-dione compound as a polymer which has a high transmittance for deep UV light of around 248 nm. However, compared with the transmittance of 70% of the base polymer of the resist, the transmittance is only approx. 40%, and enough photobleach is not obtained. Also as a result of pattern forming experiments, it is found that the pattern has an angle of approx. 70 degrees which value is insufficient compared with a pattern shape which becomes a satisfying etching mask with a vertical shape.

Also it has become clear that the sensitivity of this pattern forming material is as low as from 140 to 150 mJ/cm. That is, the high transmittant pattern forming material containing a 2-diazo-1,3-dione compound has low sensitivity, and is difficult for a practical use when there is used KrF excimer laser light of which energy efficiency is poor.

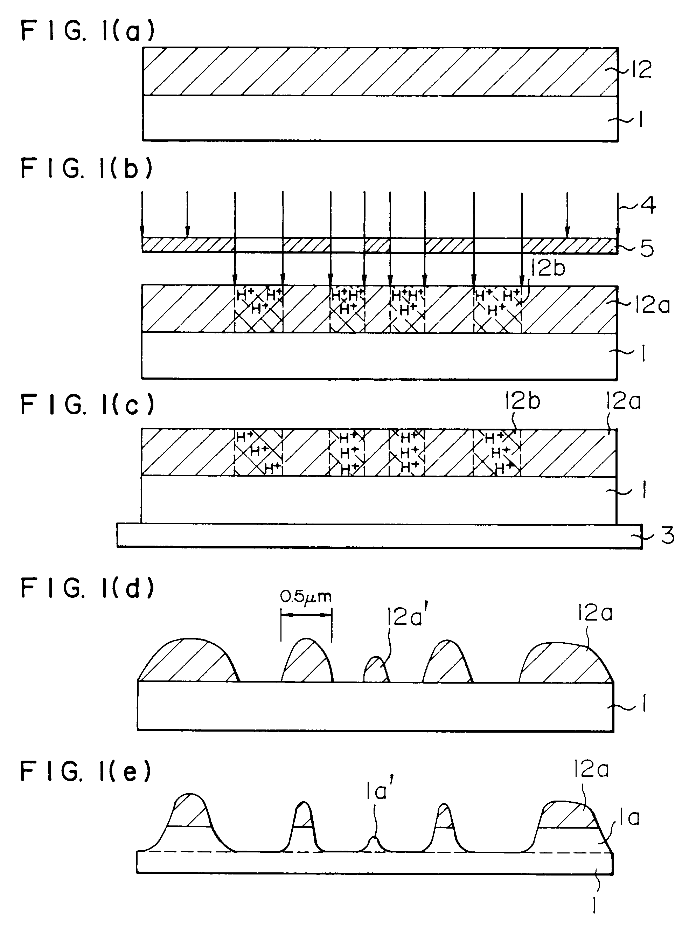

In recent years, as a means to decrease exposure energy quantity, a material comprising poly(tertial-butoxy carbonate (t-BOC)) styrene and an onium salt was proposed. This is a chemical amplification pattern forming material which generates an acid by exposure to light, said acid acting as a catalyst. Various reports have been made recently [e.g. Polym. Eng. Sci. vol. 23, page 1012 (1983)]. A pattern forming method using such a chemical amplification pattern forming material is explained referring to Fig. 1. The pattern forming material 12 is spin coated on a semiconductor substrate 1, and it is soft baked for 90 seconds on a hot plate of 90°C to obtain a 1.0 µm thick pattern forming material film (Fig. 1(a)). In most cases, an insulation film, a conductive film and an oxide film are formed on the substrate 1. Next, an acid is generated from a photoacid generator in the material 12 as shown in the following chemical change by exposure to KrF excimer laser (248.4 nm) 4 through a mask 5 (Fig. 1(b)). 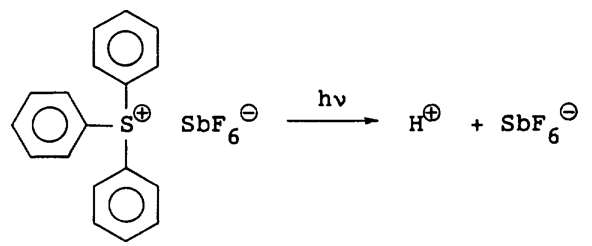 Then, the chemical change mentioned below is caused by the heat treatment (post exposure bake) of the said material film on a hot plate for 90 seconds at 130°C, and the resin becomes alkali soluble (Fig. 1(c)). 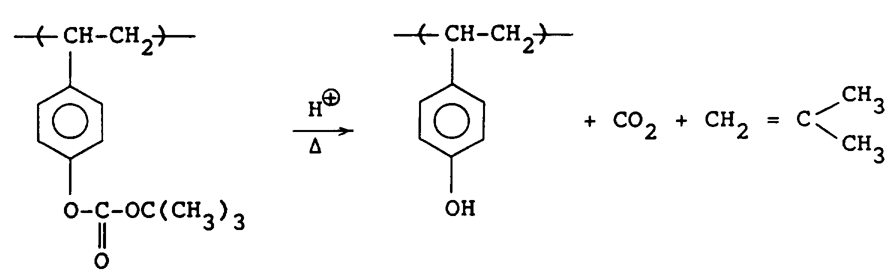 Finally, positive type pattern 12a and 12c are obtained by dissolution and removal of exposed part 12 of the pattern forming material 12 by using an alkaline developer (MF-319, mfd. by Shipley Co.) (Fig. 1(d)).

But, according to the present inventors' investigations, the shape of resist pattern 12a is extremely bad when it becomes very fine and it is proved to be unsuitable as a resist pattern. That is, the resist pattern 12a thus formed is used as an etching mask for dry etching by F₂ plasma to perform etching on the upper part of the substrate 1 to obtain a surface pattern 1a on the substrate (Fig. 1(e)).

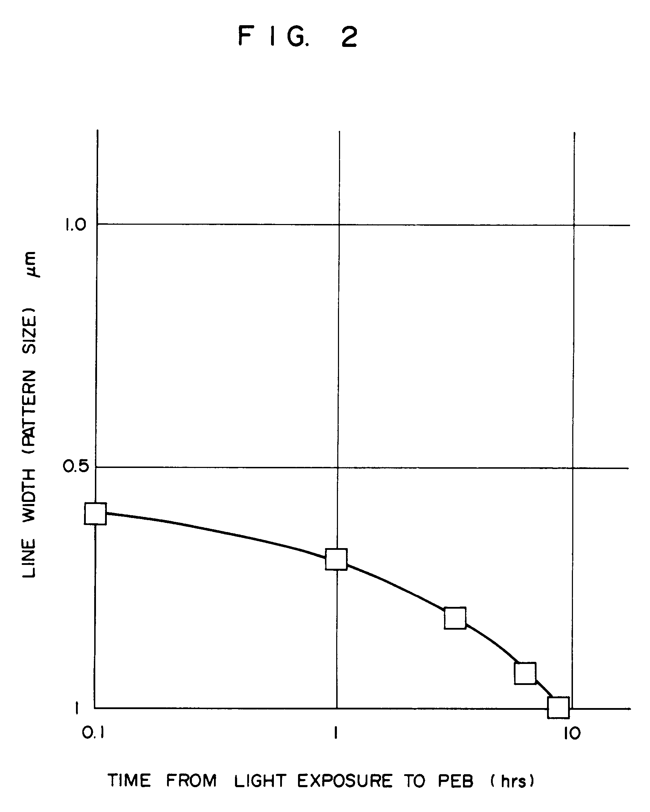

Since the substrate pattern 1a of the above method uses the insufficient resist pattern 12a as a mask, the size becomes smaller than the designed size by 0.2 - 0.5 µm and the pattern angle becomes approx. 70°. It is almost impossible to form the substrate pattern 1a′ which corresponds to especially fine resist pattern 12a′. That the substrate pattern cannot be formed as the designed size of the mask is not a problem in a relatively large pattern size (several µm level) but this difference in the size becomes an important factor in the formation method of super fine patterns of 1 µm or less, especially 0.5 µm or less, resulting in influencing greatly on the reliability and yield of semiconductor elements. Deterioration of the pattern angle also greatly affect device characteristics and as a result, it is impossible to form a device as designed. It is proved that the reason why the pattern shape is poor lies in low heat resistance of the resin used as a pattern forming material. The glass transition temperature (Tg) of poly(t-BOC) styrene resin used as a known pattern forming material is 100°C or lower. Thus, the resin softens during the heating process after exposure so as to disperse the generated acid by, for example, a usual PEB (post exposure bake) process (110°C - 150°C), resulting in failing to obtain a good pattern shape. That is, when this pattern forming material is used, the pattern size is changed as well as the pattern shape becomes out of shape, and as a result, the performance of resist which becomes an etching mask deteriorates to a considerable degree. Therefore, it is extremely important to prevent such deterioration in shape especially in the production of profitable super fine semiconductor integrated circuits in which super fine resist patterns of 1 µm or less, particularly 0.5 µm or less with high precision. It has been proved that the pattern size of these chemical amplification type resists change by heating the substrate (the said PEB (post exposure bake)) to disperse the generated acid after exposure as shown in Fig. 2. For instance, the size change caused by PEB performed one hour after exposure is over 20%. When this is applied to the production of semiconductor device of super fine rule, pattern sizes between wafers on chips becomes uneven affecting greatly on profitability, reliability and characteristics of the semiconductor elements, accordingly it is impossible to form a device as designed. The present inventors found that the reason of pattern size change is that the functional group in the resin shows alkali soluble reaction during the exposure.

Conventional poly(t-BOC)styrene resin shows the below reaction which is the same one as under acid ambience by deep ultraviolet. 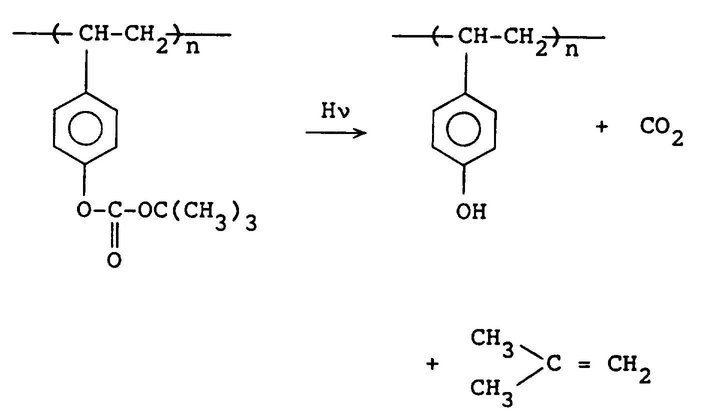 As seen above, the resin becomes to show the alkali soluble property in this exposure process before dispersing the generated acid by exposure through the PEB process. Therefore, the pattern size changes depending on the period between the exposure and the PEB. Poly(t-BOC)-styrene has two points where the linkage is weak (shown by ↑) in the functional group. 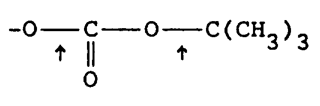 The linkages are easily cut off not only by acid ambience but also by exposure to light. That is, because the t-BOC moiety has many points where the linkage is weak, separation by exposure easily occurs. In short, this is considered to cause the size change. Consequently it is extremely important to prevent this in the production of a semiconductor integrated circuit with super fine patterns of which size allowance is small.

A positive resist composition is described in EP-A-0 366 590, a publication only relevant to this present disclosure by virtue of Art. 54(3) and (4) EPC. That composition comprises a polymeric material and a photoinitiator which generates a strong acid. Polystyrene is proposed as the polymer backbone.

### SUMMARY OF THE INVENTION

It is an object of this invention to provide a method for forming fine patterns with high precision in size by using a chemical amplification type pattern forming material with a functional group having high photo stability.

This invention relate to a resist pattern forming method used for the production of semiconductor elements and others, and to a pattern forming method to form positive tone patterns using ultra violet light excimer laser of 400 nm or less, for instance, as an exposure energy source.

The present invention provides a process for forming a pattern which comprises
forming on a substrate a film of pattern forming material comprising (a) a resin having functional groups being able to be alkali-soluble under an acid atmosphere and a moiety having heat resistance, (b) a photosensitive compound being able to generate an acid by exposure to light and selected from the group consisting of 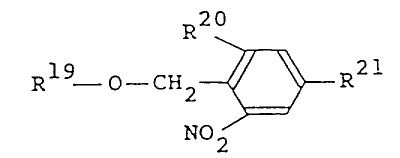 wherein R¹⁹ is a trichloroacetyl group, a p-toluene-sulfonyl group, a p-trifluoromethylbenzenesulfonyl group, a methanesulfonyl group or a trifluoromethanesulfonyl group; and R⁰ and R¹ are independently a hydrogen atom, a halogen atom or a nitro group, 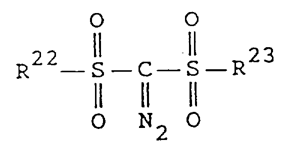 wherein R and R³ are independently a straight-chain, branched or cyclic alkyl group, a haloalkyl group or a group of the formula: 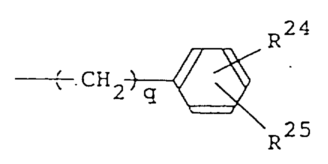 wherein q is zero or an integer of 1 or more; R⁴ and R⁵ are independently a hydrogen atom, a halogen atom, a straight-chain, branched or cyclic alkyl group, a haloalkyl group, an alkoxy group, a nitro group or a cyano group, 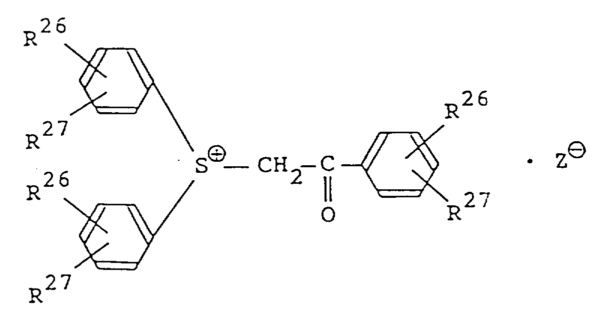 wherein R⁶ and R⁷ are independently a hydrogen atom, a halogen atom, a straight-chain, branched or cyclic alkyl group or an alkoxy group; and Z^{⊖} is a perchlorate ion, a toluenesulfonate ion, or a trifluoromethansulfonate ion, 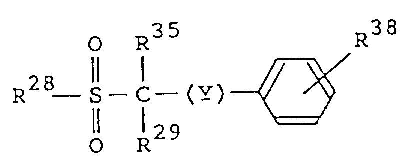 wherein Y is a carbonyl group, a sulfonyl group or a sulfinyl group; R⁸ is a lower alkyl group, a trifluoromethyl group, a phenyl group or an alkyl-substituted phenyl group; R⁹ and R³⁵ are independently a lower alkyl group, a halogen atom or a hydrogen atom; and R³⁸ is a hydrogen atom, a halogen atom, a lower alkyl group, an alkoxy group or an alkylthio group, and 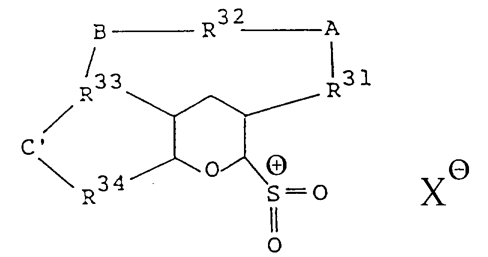 wherein X^{⊖} is a counter ion, R³¹, R³, R³³ and R³⁴ are independently a hydrogen atom, a halogen atom, a straight-chain, branched or cyclic alkyl group, a haloalkyl group, an alkoxy group, an aralkyl group, a substituted phenyl group, a phenyl group, a nitro group or a cyano group; and R³¹ - R³, R³ - R³³ and R³³ - R³⁴ independently form an aliphatic ring, a heteroaliphatic ring, an aromatic ring or a hetero aromatic ring via A, B and C', respectively, each having 5 to 8 carbon atoms, and (c) a solvent for dissolving both the components (a) and (b),
exposing the film selectively to deep ultraviolet light,
heating the exposed film, and
developing the resulting film using an alkali developer to form the desired pattern.

In the above-mentioned process, it is preferable to use as the resin (a) that having the repeating units of the formula: 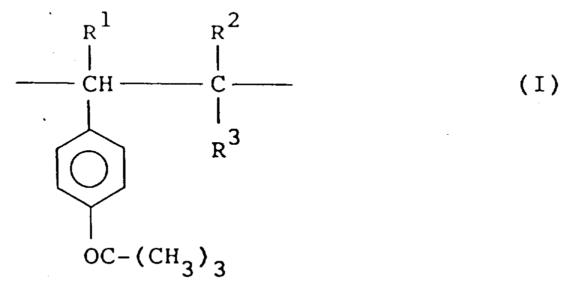 wherein R¹, R and R³ are independently a hydrogen atom, a halogen atom or a lower alkyl group, and further backbone units having a group imparting improved heat resistance, said group being at least one of an imido group, an amido group, a phenyl group, a hydroxyphenyl group, a chlorophenyl group, or a cyano group.

### BRIEF DESCRIPTION OF THE DRAWINGS

Figs. 1(a) to 1(e) are cross-sectional views explaining the steps of a prior art pattern forming process.

Fig. 2 shows line-width variation dependence on the time from the light exposure to PEB in a prior art pattern forming method.

Figs. 3(a) to 3(e) are cross-sectional views explaining the process of this invention.

Fig. 4 is a UV spectral diffraction curve of a pattern forming material of Example 1 of this invention (the solid line means before exposure and the broken line means after exposure).

Fig. 5 shows irradiation characteristics of a pattern forming material of Example 1 of this invention.

Fig. 6 is a line-width variation dependence on the time from the light exposure to PEB in the pattern forming method of this invention.

### DESCRIPTION OF THE PREFERRED EMBODIMENTS

This invention is explained concretely as follows. An acid is generated from a photosensitive compound (or photoacid generator) exposed to KrF excimer laser light or deep ultraviolet light. Functional groups of a resin are photochemically changed by the acid into an alkali-soluble state by the heat treatment after the exposure process and released into a developer at the time of development. On the other hand, since the acid is not generated on an unexposed part, the photochemical change does not occur during the heat treatment, resulting in not producing an alkali-soluble group.

Also, since the resin itself has high heat resistance, softening of the resin is not seen during the heat treatment. Since there is a large difference in solubility in the alkali developer between the exposed part and the unexposed part, and the resin in the unexposed part is not softened during the heat treatment, positive tone patterns with good contrast can be formed by the method of this invention. Also since the acid generated by the exposure functions as a catalyst, the exposure to light is sufficient to generate only a necessary amount of acid, resulting in reducing the exposure energy. Further, softening of the resin caused by the PEB process (heat treatment) as mentioned above brings about an error between the actual patterns and the designed size and deteriorates the pattern angles. These disadvantages are not important factors in the prior art semiconductor process (rule over 1 µm), but they become factors which greatly affect the characteristics, productivity and reliability of the device in the super fine device formation of 1 µm or less, especially 0.5 µm or less. Accordingly, the pattern forming method of this invention, wherein the resin is improved in heat resistance and good pattern angles with the designed size can be formed, is remarkably effective in the production of semiconductor devices with super fine rule.

This invention provides a pattern forming method using a new pattern forming material with high sensitivity and high contrast to ultraviolet light, especially KrF excimer laser, and high heat resistance and stability to super fine lithographic process. Since this invention is applicable to super fine devices of 0.3 µm rule , it has a great industrial value in the promotion of micronization of semiconductor elements and in the improvement of productivity. Further changes of the resist pattern size depending on the period from the exposure to light to PEB as mentioned above bring about an error between the actual patterns and the designed size. Although these are not important factors in a prior art semiconductor process (rules over 1 µm), they are the factors which greatly affect the device characteristics, productivity and reliability in the process for forming super fine device of 1 µm or less, especially 0.5 µm or less. Since the formation of resist patterns with the exact size as designed is possible through the pattern formation by introducing functional groups with high photostability, that is, a tert-butoxy group into the resin in the pattern forming material, this invention is indispensible in the production of a semiconductor device with super fine rule.

This invention is explained more in detail below.

The present inventors considered that the softening of pattern shape lies in low heat resistance of the resin and examined the use of a pattern forming material containing a resin obtained by copolymerizing with ingredients with high heat resistance and functional groups which become alkali-soluble in the acid ambience. It is possible to adjust Tg of the resin over 200°C at maximum by introducing ingredients with high heat resistance into the resin, and as a result, it is possible to give high heat resistance to the pattern forming material. As a result of various investigations of the ingredients to improve heat resistance, the present inventors found that ingredients having a group of imido, amido, phenyl, hydroxyphenyl, chlorophenyl, or cyano remarkably improve the heat resistance. However the heat resistant component used in this invention is not limited to these.

Also some examples of functional group are methyl, isopropyl, tert-butyl, methoxymethyl, isopropoxymethyl, tetrahydropyranyl, tetrahydrofuranyl, trimethylsilyl, tert-butoxycarbonyl, and isopropoxycarbonyl. However, other functional groups can also be used so long as they become alkali-soluble in acid ambience and not limited thereto. As mentioned above, the tert-butoxy group is considered to be the best in terms of the stability in size.

As to the photoacid generator (b), any photoacid generator can be used so long as it generates an acid by exposure to light, e.g. nitrobenzyl compounds, onium salts, sulfonic acid compounds and carbonyl acid compounds.

As to the solvent, any solvent can be used so long as it dissolves the resin (a) and the photoacid generator (b).

The temperature of PEB is preferably from 90°C to Tg of the resin. When the temperature is lower than 90°C, the photoacid generator does not function effectively and it is impossible to obtain a good pattern with high sensitivity. On the other hand, when the temperature is higher than Tg, softening of the resin takes place and it is impossible to obtain a good pattern.

On the other hand, the present inventors considered that a reason for changes of the pattern dimension lies in poor photo stability of the functional group of the resin as stated before, and found a method to use a pattern forming material containing a resin having functional groups showing alkali-soluble property in acid ambience with high photo stability. By introducing the functional group showing the alkali-soluble property in the acid ambience with high photo stability into the resin, only acid generation reaction takes place in the light exposure process, and alkali soluble reaction can take place only during the subsequent PEB process. Therefore, the parameter determining the pattern size is only the two mentioned above and no longer depends on the time from the light exposure to PEB. This means that the present invention is a pattern forming method with high precision in dimension. As a result of various investigations on said functional group, the present inventors found that a tert-butoxy group is more preferable in the photostability and in bringing about the alkali-soluble reaction with high sensitivity in the acid atmosphere.

This invention is illustrated further in detail with reference to Examples but not limited thereto.

### Example 1

A pattern forming material was prepared using the following ingredients:.

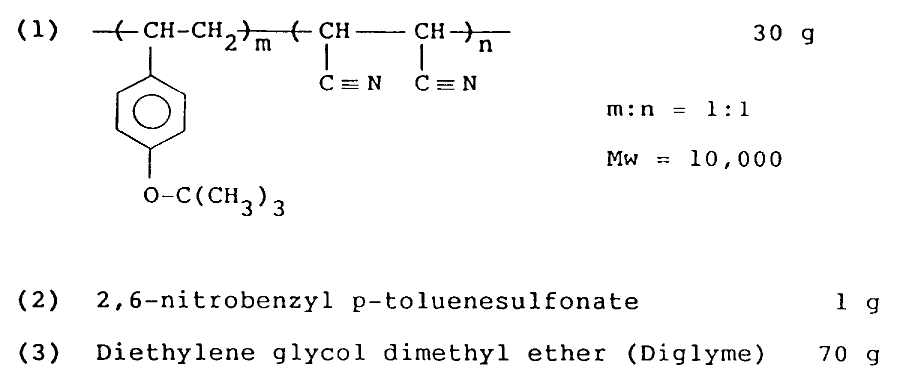

This is an example wherein in the resin (1), tert-butoxy group is used as a functional group that shows an alkali-soluble property under an acid atmosphere, and C ≡ N (cyano) is used as a moiety to improve heat resistance. Linkage of C-O in the tert-butoxy group is cut off by heating under acid atmosphere as shown before, and as a result, a hydroxyl group is formed.

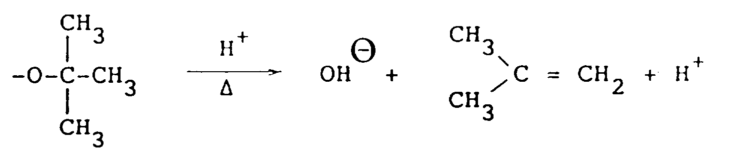

The compound (2) is used as a photoacid generator. The following reaction takes place by exposure to light:

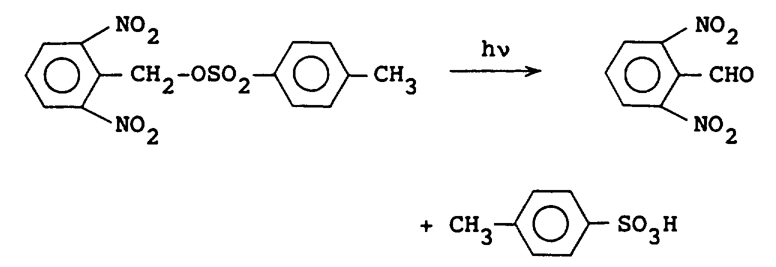

The compound (3) is an example of the solvent which can dissolve both (1) and (2) mentioned above. Since it has very high transmittance in the deep UV region, a good result is exhibited by the use of such a solvent for a pattern forming material for KrF excimer laser. The tert-butoxy group has only one weak linkage in the functional group. Moreover, this bonding is bigger in strength than usual t-BOC, and is 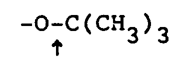 not easily cut off by the exposure to light. In short, the alkali-soluble reaction takes place only in the PEB process, so that changes in the pattern size are not produced.

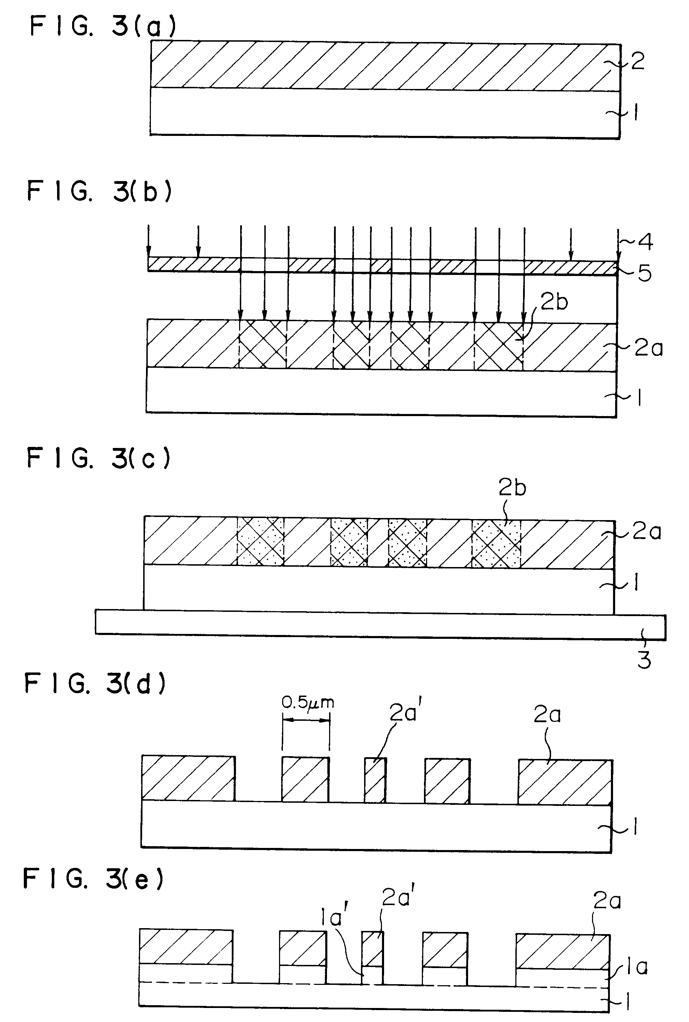

Now, the pattern forming method is explained referring to Fig. 3. A 1.0 µm thick pattern forming material film is obtained by spin coating the pattern forming material 2 on a semiconductor substrate such as silicon 1 to produce a resist thin film, baking it at 90°C for 90 sec. on a hot plate 3 and removing the solvent in the thin film by evaporation (Fig. 3(a)). The substrate 1 may have an insulation film, an electroconductive film or a semiconductor film on the surface thereof. Next, the photoacid generator (2) is subjected to photo decomposition as mentioned above by exposing to 248.4 nm KrF excimer laser 4 through a mask 5 (Fig. 3(b)). Then, the film is baked (PEB) at 130°C for 90 sec. on the hot plate 3 to bring about the alkali-solubilizing reaction on the tert-butoxy group as stated before (Fig. 3(c)). Then, by developing it with an alkali developer (2.38% tetramethylammonium hydroxide (TMAH)) for 60 sec., the exposed part 2b of the pattern forming material is removed through dissolution to obtain a positive tone resist pattern 2a (Fig. 3(d)). Finally, a dry etching method with F₂ plasma is applied to the surface of the substrate 1, using the positive tone resist pattern 2a as a mask to obtain the substrate pattern 1a (Fig. 3(e)). There are many cases that the pattern 1a is the pattern of insulation film, electroconductive film and semiconductor film. Thus, the substrate pattern 1a which has copied the resist pattern 2a can be obtained. As clearly shown in Figs. 3(d) and 3(e), the substrate pattern 1a is also formed accurately because the shape of the resist pattern 2a shows no deformation. As obviously seen in Fig. 3, also among the patterns 2a and 1a, the super fine pattern 2a of 0.5 µm or less and the substrate pattern 1a can be certainly formed with high productivity.

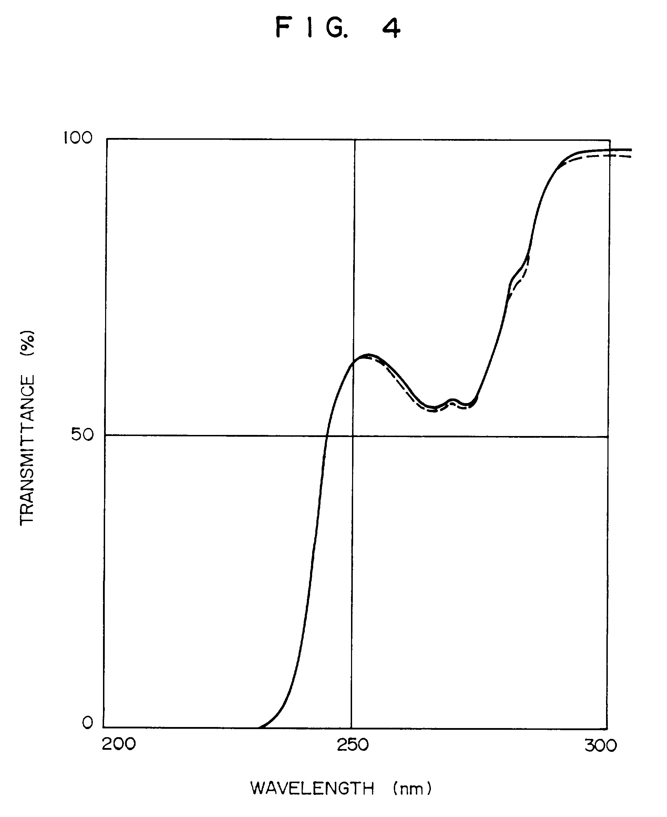

UV spectral diffraction curves of the pattern forming material used in this invention are shown in Fig. 4. Fig. 4 shows high transmittance of approx. 65% with no changes before and after the exposure. Improvement in transmittance improves photosensitivity at the bottom of the resist, consequently good pattern profile with high sensitivity can be expected. As a result of pattern forming experiments, it was possible to form a 0.3 µm line and space pattern which has a good shape as resist pattern 2a with no prior art peeling problem of the pattern.

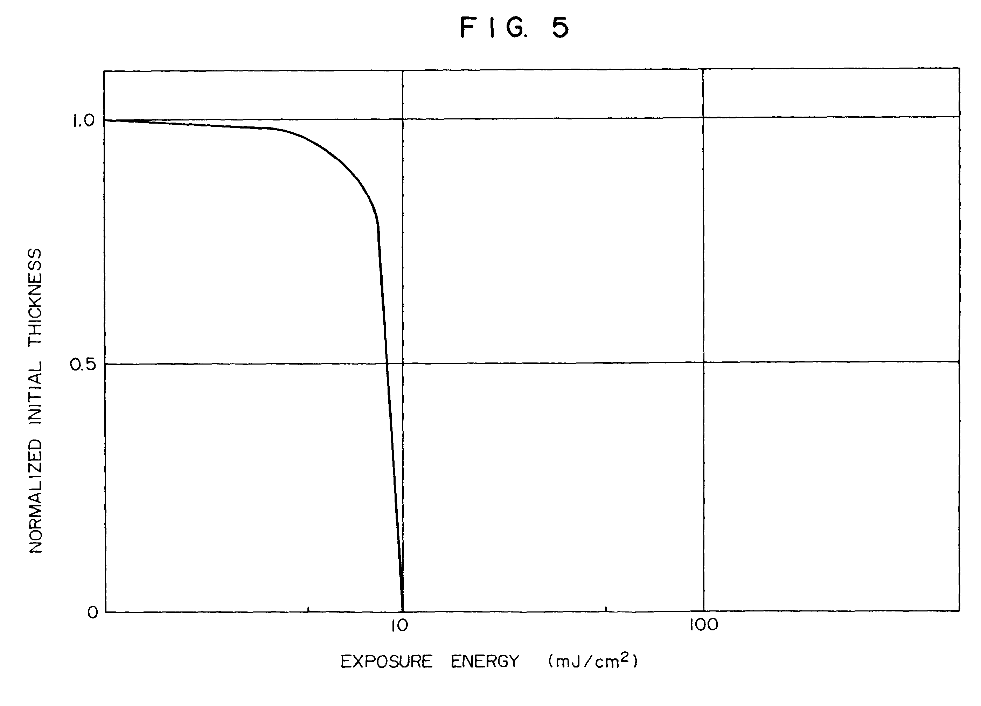

Furthermore, irradiation characteristics of this pattern forming material (1 µm) are shown in Fig. 5, which shows high contrast and high sensitivity. The γ value was 5.5 and sensitivity was 10 mJ/cm. Here, resolution limit and the comparison between the pattern forming material of one example of this invention and prior art material are shown in Table 1.

**Table 1**

| Items for comparison | | Pattern forming method of this invention (2a) | Prior art pattern forming method (12a) |
|---|---|---|---|
| Resolution (µm) | | 0.3 | 0.4 |
| Heat resistance | Tg of resin (°C) | 200° or higher | 90 |
| | Formed resist pattern (°C) | 200° or higher | 100 |
| Pattern angle on resist and substrate (degree) | | 90 | 70 |
| Error between designed size and pattern size (µm) | Resist pattern | 0.0 | 0.2 - 0.3 |
| | Substrate pattern | 0.0 | 0.3 - 0.5 |

In the method using prior art pattern forming material, resolution is 0.4 µm and because Tg of the resin is 90°C, the resin is softened during the PEB process (110°C). Accordingly, the pattern angle of the formed resist patterns is approx. 70° and an error is produced at max. 0.3 µm from the designed size. The difference of 0.3 µm is not a big problem in the device with a large device rule, but it is a serious problem in the submicron rule device. Also since the pattern shape is poor, the size shift becomes even bigger after etching, according to the inventors' experiments, a size difference of 0.5 µm at max. being produced.

The low Tg of resin also lowers heat resistance of the resist itself (approx. 100°C). Consequently the heat treatment such as post baking becomes difficult, and a proper etching mask cannot be obtained.

On the other hand, in the method using the pattern forming material of this invention, Tg of the resin is 200°C or higher. Thus, the heat resistance is excellent when this material is used as a resist. This resist is not softened during the PEB process, so that the resist patterns with a good pattern profile can be formed as designed. It is also not softened during the post baking process and an error with the designed size is not seen at all after the etching process.

This invention enables to form fine patterns as designed in a good shape, and as a result, a super fine and high density semiconductor device can be fabricated with the designed characteristics, reliability and high productivity. This is extremely significant in the production of a device of subhalf micron.

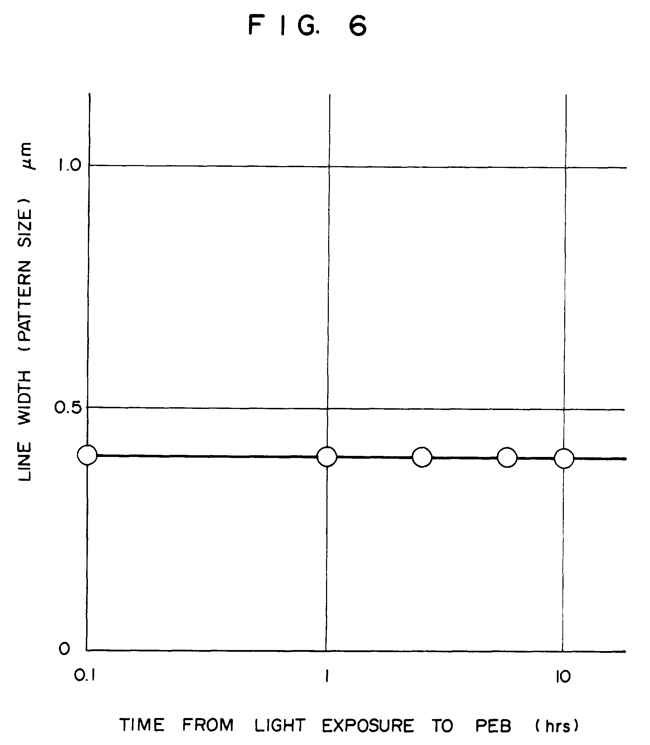

Fig. 6 shows the dependency of the pattern size on the time from the light exposure to PEB in the pattern forming method of this invention. Changes in the pattern size was not seen after 10 hours. In short, in the pattern forming method of this invention, super fine patterns of 0.5 µm or less can be formed in a good shape as designed. As a result, a semiconductor device can be formed with the designed characteristics, reliability and high productivity. This is very significant in the production of a subhalf micron device.

### Example 2

The process of Example 1 was repeated except for using the following photoacid generator: 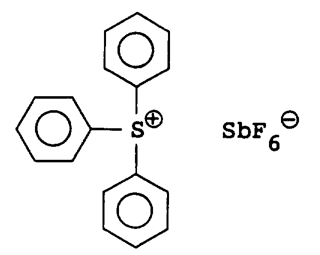 As a result, a good result of sensitivity of 5 mJ/cm was obtained as in Example 1.

### Example 3

The process of Example 1 was repeated except for using the following photoacid generator: 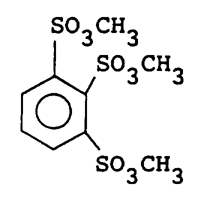 As a result, a good result of sensitivity of 15 mJ/cm was obtained as in Example 1.

### Example 4

The process of Example 1 was repeated except for using the following resin:

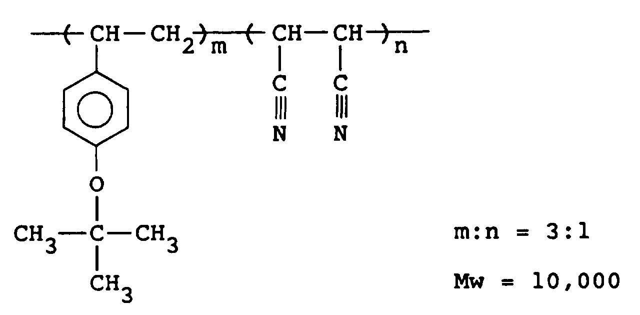

This resin introduces a heat resistance improving group (C ≡ N) in a less proportion than that of Example 1. However, this resin has enough heat resistance usable as a pattern forming material because Tg is 160°C. As a result of experiments, the same good result as in Example 1 was obtained.

### Example 5

The process of Example 1 was repeated except for using the following resin:

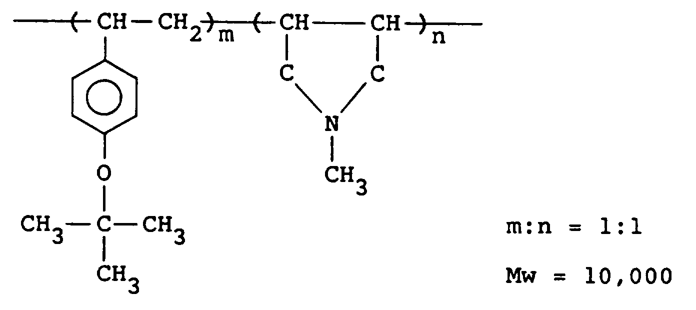

In this resin, an imido bonding is introduced to improve heat resistance. As a result of the experiments, a good result as in Example 1 was obtained.

### Example 6

The process of Example 1 was repeated except for using the following resin: 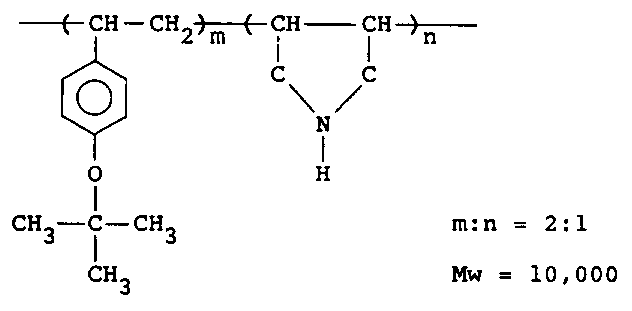 As a result, the same good result as in Example 1 was obtained.

### Example 7

The process of Example 1 was repeated except for using the following resin:

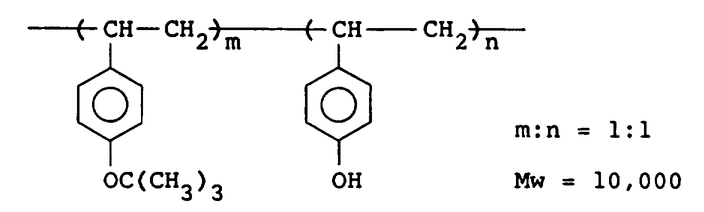

Poly(para-styrene) was introduced into the molecule of this resin to improve its heat resistance, resulting in making Tg of this resin 160°C. At the same time, by introducing the alkali-soluble group (-OH) into the molecule, improvement of adhesiveness to the hydrophobic substrate was aimed at.

The comparison between the pattern forming material of an embodiment of this invention and the prior art material are shown in Table 2.

**Table 2**

| Material of substrate 1 | Items for evalution | Pattern forming method of this invention (2a) | Prior art pattern forming method (12a) |
|---|---|---|---|
| Silicon | Resolution (µm) | 0.3 | 1.0 |
| | Pattern angle (degree) | 90 | 90 |
| | Sensitivity (mJ/cm) | 10 | 15 |
| SiO₂ | Resolution (µm) | 0.3 | 2.0 or more |
| | Pattern angle (degree) | 90 | 90 |
| | Sensitivity (mJ/cm) | 10 | 14 |
| Spin on glass (SOG) | Resolution (µm) | 0.3 | 2.0 |
| | Pattern angle (degree) | 90 | 90 |
| | Sensitivity (mJ/cm) | 10 | 16 |

Improvement of the adhesiveness between the pattern forming material and the substrate is extremely significant in the pattern formation on the film which is conventionally considered difficult to form patterns on a substrate with high hydrophile property such as SiO₂ film, Si₃N₄ film, spin on glass (SOG) film, etc. As shown in Table 2, 0.3 µm L/S patterns in a good shape were formed according to the present invention.

### Example 8

The process of Example 1 was repeated except for using the following resin:

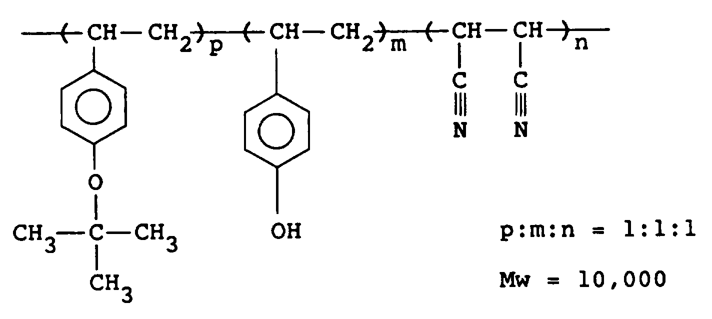

Poly(para-vinyl phenol) and C ≡ N were introduced into the molecule to improve the heat resistance, and a hydroxyl group was also introduced to improve adhesiveness at the same time. As a result, good result as in Example 1 was obtained.

### Example 9

The process of Example 8 was repeated except that the pattern forming material film was formed on the SOG formed on the substrate. As a result, there were obtained 0.3 µm line and space patterns with good shape and good adhesiveness without peeling as in Example 8.

### Example 10

The process of Example 9 was repeated except for using as the developer an aqueous solution of TMAH 2.38% (tetramethylammonium hydroxide) and isopropanol 10%. It turned out that polarity was produced in the developer by mixing with an alcohol such as isopropanol, and wettability with the pattern forming material film was improved. Improvement in wettability of the developer with the pattern forming material increases a dissolving speed of the pattern forming material at the exposed part, resulting in making it possible to have higher sensitivity. As a result, the same good result as in Example 9 was obtained with high sensitivity of 3.5 mJ/cm.

In this Example, isopropanol is used as the developer. It is also possible to use other alcohols such as methanol, ethanol, n-propanol, n-butanol and isobutanol so long as the polarity is added to the developer.

Further, in this Example, the tert-butoxy group with high stability was used as an example of the group which shows alkali-soluble property under an acid atmosphere. It is also possible to use other functional groups such as a tert-butoxycarbonate group, an isopropoxycarbonate group, a tetrahydropyranyl group, a tetrahydrofuranyl group and a trimethylsilyl group.

As to the photoacid generator, any compounds having good solution stability and acid generating efficiency can be used. Preferable examples of the photoacid generator are as follows. 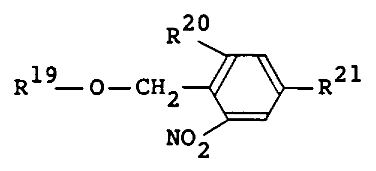 wherein R¹⁹ is a trichloroacetyl group, a p-toluenesulfonyl group, a p-trifluoromethylbenzenesulfonyl group, a methanesulfonyl group or a trifluoromethanesulfonyl group; and R⁰ and R¹ are independently a hydrogen atom, a halogen atom or a nitro group. 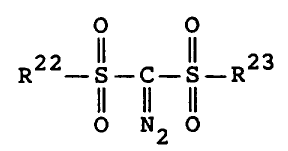 wherein R and R³ are independently a straight-chain, branched or cyclic alkyl group, a haloalkyl group or a group of the formula: 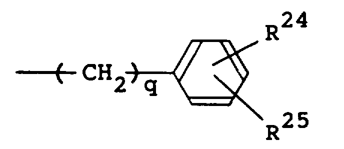 wherein q is zero or an integer of 1 or more; R⁴ and R⁵ are independently a hydrogen atom, a halogen atom, a straight-chain, branched or cyclic alkyl group, a haloalkyl group, an alkoxy group, a nitro group or a cyano group. 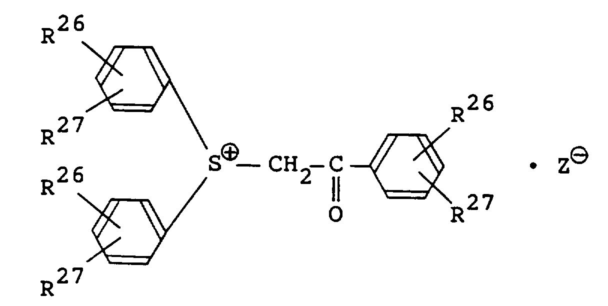 wherein R⁶ and R⁷ are independently a hydrogen atom, a halogen atom, a straight-chain, branched or cyclic alkyl group or an alkoxy group; and Z^{⊖} is a perchlorate ion, a toluenesulfonate ion, or a trifluoromethansulfonate ion. 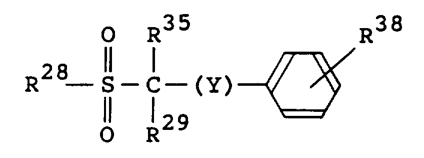 wherein Y is a carbonyl group, a sulfonyl group or a sulfinyl group; R⁸ is a lower alkyl group, a trifluoromethyl group, a phenyl group or an alkyl-substituted phenyl group; R⁹ and R³⁵ are independently a lower alkyl group, a halogen atom or a hydrogen atom; and R³⁸ is a hydrogen atom, a halogen atom, a lower alkyl group, an alkoxy group or an alkylthio group. 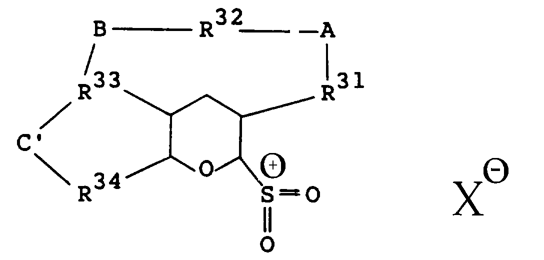 wherein X^{⊖} is a counter ion, R³¹, R³, R³³ and R³⁴ are independently a hydrogen atom, a halogen atom, a straight-chain, branched or cyclic alkyl group, a haloalkyl group, an alkoxy group, an aralkyl group, a substituted phenyl group, a phenyl group, a nitro group or a cyano group; and R³¹ - R³, R³ - R³³ and R³³ - R³⁴ independently form an aliphatic ring, a heteroaliphatic ring, an aromatic ring or a hetero aromatic ring via A, B and C', respectively, each having 5 to 8 carbon atoms.

As to the solvent, diethylene glycol dimethyl ether which shows low absorption in the deep ultraviolet light region in this Example. But any solvents that can dissolve the resin and the photoacid generator can be used. Examples of the solvent are ethyl Cellosolve acetate, methyl Cellosolve acetate, ethyl lactate, methyl lactate, diethylene glycol monomethyl ether, diethylene glycol monobutyl ether, etc. but not limited thereto.

The temperature of PEB is preferably from 90°C to Tg of the resin. When the temperature is lower than 90°C, the photoacid generator does not function effectively to fail to obtain a good pattern with high sensitivity. On the other hand, when the temperature is higher than Tg, softening of the resin takes place to fail to obtain a good pattern.

As to the exposure light source, those that generate an acid by the exposure can be used. Examples of the light source are g-line (436 nm), i-line (365 nm), electron beams, X-rays, etc.

## Claims

1. A process for forming a pattern which comprises forming on a substrate a film of pattern forming material comprising (a) a resin having functional groups being able to be alkali-soluble under an acid atmosphere and a moiety having heat resistance, (b) a photosensitive compound being able to generate an acid by exposure to light, and selected from the group consisting of 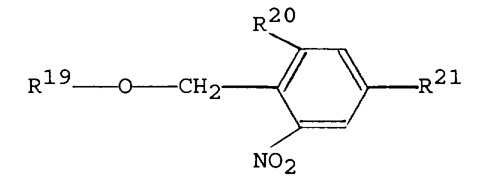 wherein R¹⁹ is a trichloroacetyl group, a p-toluene-sulfonyl group, a p-trifluoromethylbenzenesulfonyl group, a methanesulfonyl group or a trifluoromethanesulfonyl group; and R⁰ and R¹ are independently a hydrogen atom, a halogen atom or a nitro group, 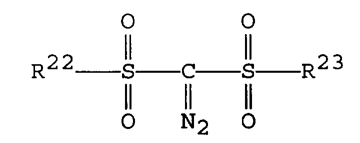 wherein R and R³ are independently a straight-chain, branched or cyclic alkyl group, a haloalkyl group or a group of the formula: 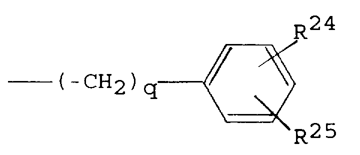 wherein q is zero or an integer of 1 or more; R⁴ and R⁵ are independently a hydrogen atom, a halogen atom, a straight-chain, branched or cyclic alkyl group, a haloalkyl group, an alkoxy group, a nitro group or a cyano group, 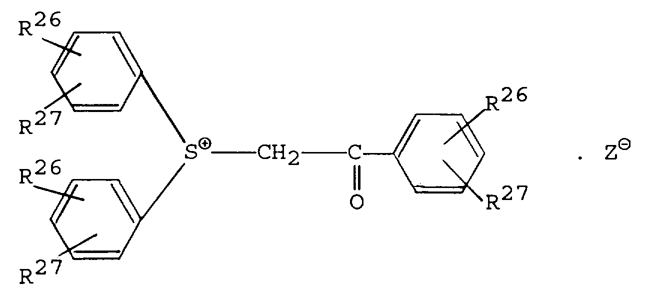 wherein R⁶ and R⁷ are independently a hydrogen atom, a halogen atom, a straight-chain, branched or cyclic alkyl group or an alkoxy group; and Z^{⊖} is a perchlorate ion, a toluenesulfonate ion, or a trifluoromethansulfonate ion, 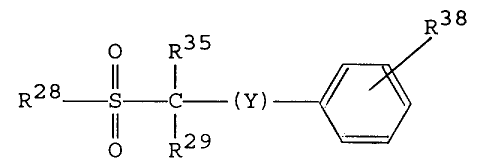 wherein Y is a carbonyl group, a sulfonyl group or a sulfinyl group; R⁸ is a lower alkyl group, a trifluoromethyl group, a phenyl group or an alkyl-substituted phenyl group; R⁹ and R³⁵ are independently a lower alkyl group, a halogen atom or a hydrogen atom; and R₃₈ is a hydrogen atom, a halogen atom, a lower alkyl group, an alkoxy group or an alkylthio group, and 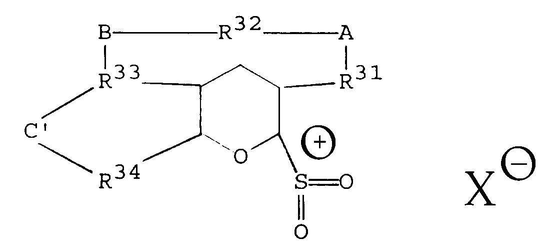 wherein X^{⊖} is a counter ion, R³¹, R³, R³³ and R³⁴ are independently a hydrogen atom, a halogen atom, a straight-chain, branched or cyclic alkyl group, a haloalkyl group, an alkoxy group, an aralkyl group, a substituted phenyl group, a phenyl group, a nitro group or a cyano group; and R³¹ - R³, R³ - R³³ and R³³ - R³⁴ independently form an aliphatic ring, a heteroaliphatic ring, an aromatic ring or a hetero aromatic ring via A, B and C', respectively, each having 5 to 8 carbon atoms, and (c) a solvent for dissolving both the components (a) and (b),
exposing the film selectively to deep ultra-violet light,
heating the exposed film, and
developing the resulting film using an alkali developer to form the desired pattern.

2. A process according to Claim 1, wherein the resin (a) is obtained by copolymerizing:
(i) styrene having substituted thereon functional groups being able to be made alkali-soluble under an acid atmosphere, and
(ii) a monomer having a group showing high heat resistance which is selected from the group consisting of unsubstituted phenyl, hydroxyphenyl, chlorophenyl, cyano, imido and amido.

3. A process according to claim 1 or 2, wherein the functional group is a methyl group, an isopropyl group, a tert-butyl group, a methoxymethyl group, an isopropoxymethyl group, a tetrahydropyranyl group, a tetrahydrofuryl group, a trimethylsilyl group, a tert-butoxycarbonyl group, or an isopropoxycarbonyl group.

4. A process according to Claim 1, 2 or 3, wherein the functional group is a tert-butoxycarbonyl group.

5. A process according to Claim 1, wherein the resin (a) has the repeating units of the formula: 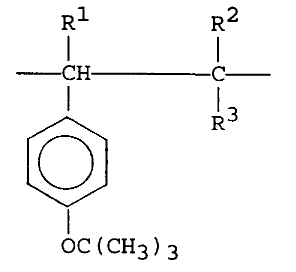 wherein R¹, R and R³ are independently a hydrogen atom, a halogen atom or a lower alkyl group, and further backbone units having a group imparting improved heat resistance, said group being at least one of an imido group, an amido group, a phenyl group, a hydroxyphenyl group, a chlorophenyl group, or a cyano group.

6. A process according to Claim 1 or 2, wherein the resin has repeating units of the formula: 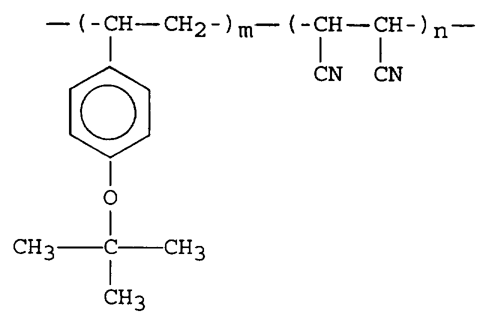 wherein m:n is 1:1 to 3:1.

7. A process according to Claim 1 or 2, wherein the resin has repeating units of the formula: 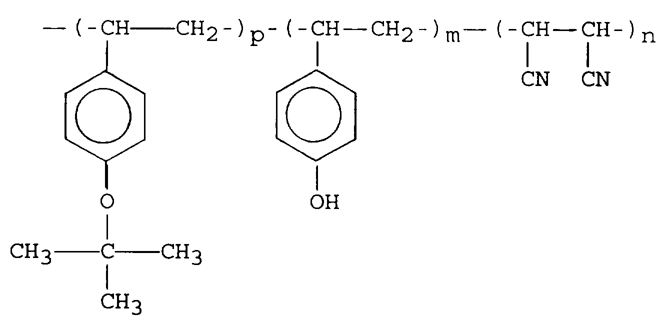 wherein p:m:n is 1:1:1.

## Patentansprüche

1. Verfahren zum Ausbilden eines Musters, das aufweist: Ausbilden eines Films aus einem Musterausbildungsmaterial auf einem Substrat, wobei das Musterausbildungsmaterial aufweist: (a) einen Kunststoff mit in einer sauren Umgebung alkalilöslichen funktionellen Gruppen und einem eine Wärmebeständigkeit aufweisenden Bereich, (b) eine photoempfindliche Verbindung, die bei Belichtung zur Erzeugung einer Säure fähig ist, und ausgewählt ist aus der Gruppe bestehend aus: 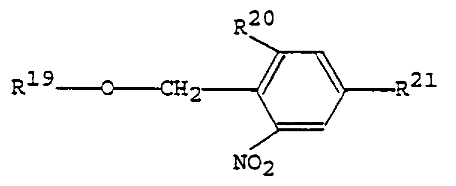 wobei R¹⁹ eine Trichloroacetylgruppe, eine p-Toluol-Sulfonylgruppe, eine p-Trifluoromethylbenzolsulfonylgruppe, eine Methansulfonylgruppe oder eine Trifluoromethansulfonylgruppe ist und R⁰ sowie R¹ unabhängig voneinander ein Wasserstoffatom, ein Halogenatom oder eine Nitrogruppe sind; 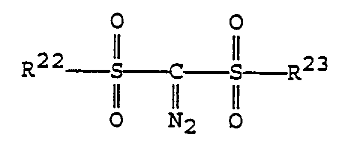 wobei R und R³ unabhängig voneinander eine geradkettige, verzweigte oder zyklische Alkylgruppe, eine Haloalkylgruppe oder eine Gruppe der Formel: 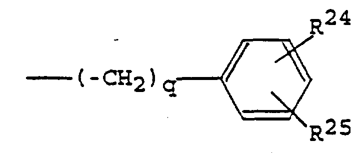 sind, wobei q Null oder eine ganze Zahl mit einem Wert von 1 oder mehr ist; R⁴ und R⁵ unabhängig voneinander ein Wasserstoffatom, ein Halogenatom, eine geradkettige, verzweigte oder zyklische Alkylgruppe, eine Haloalkylgruppe, eine Alkoxygruppe, eine Nitrogruppe oder eine Cyanogruppe sind; 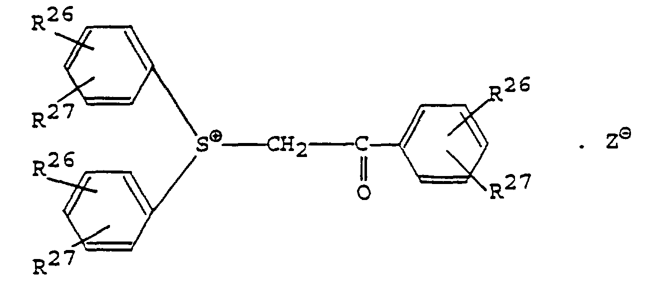 wobei R⁶ und R⁷ unabhängig voneinander ein Wasserstoffatom, ein Halogenatom, eine geradkettige, verzweigte oder zyklische Alkylgruppe oder eine Alkoxygruppe sind und Z^{⊖} ein Perchloration, ein Toluolsulfonation oder ein Trifluoromethansulfonation ist; 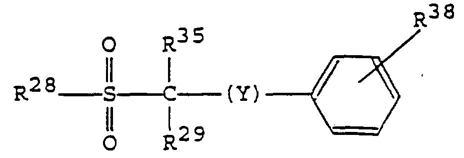 wobei Y eine Carbonylgruppe, eine Sulfonylgruppe oder eine Sulfinylgruppe ist; R⁸ eine niedrige Alkylgruppe, eine Trifluoromethylgruppe, eine Phenylgruppe oder eine alkylsubstituierte Phenylgruppe ist; R⁹ und R³⁵ unabhängig voneinander eine niedrige Alkylgruppe, ein Halogenatom oder ein Wasserstoffatom sind und R³⁸ ein Wasserstoffatom, ein Halogenatom, eine niedrige Alkylgruppe, eine Alkoxygruppe oder eine Alkylthiogruppe sind, und 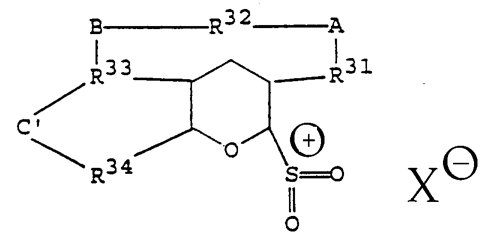 wobei X^{⊖} ein Gegenion ist, R³¹, R³, R³³ und R³⁴ unabhängig voneinander ein Wasserstoffatom, ein Halogenatom, eine geradkettige, verzweigte oder zyklische Alkylgruppe, eine Haloalkylgruppe, eine Alkoxygruppe, eine Aralkylgruppe, eine substituierte Phenylgruppe, eine Phenylgruppe, eine Nitrogruppe oder eine Cyanogruppe sind und R³¹ - R³, R³ - R³³ und R³³ - R³⁴ über A, B bzw. C', die jeweils 5 bis 8 Kohlenstoffatome aufweisen, unabhängig voneinander einen aliphatischen Ring, einen heteroaliphatischen Ring, einen aromatischen Ring oder einen heteroaromatischen Ring ausbilden, sowie (c) ein Lösungsmittel zum Lösen der beiden Bestandteile (a) und (b),
selektives Belichten des Films mit tief ultraviolettem Licht,
Erwärmen des belichteten Films und
Entwickeln des resultierenden Films unter Verwendung eines Alkalientwicklers zur Ausbildung des gewünschten Musters.

2. Verfahren nach Anspruch 1, bei dem der Kunststoff durch Copolymerisation der folgenden Bestandteil erhalten wird:
(i) Styrol mit daran substituierten funktionellen Gruppen, die in einer sauren Umgebung alkalilöslich sind, und
(ii) einem Monomer mit einer eine hohe Wärmebeständigkeit zeigenden Gruppe, die ausgewählt ist aus der Gruppe bestehend aus einer unsubstituierten Phenyl-, einer Hydroxyphenyl-, einer Chlorophenyl-, einer Cyano-, einer Imido- und einer Amidogruppe.

3. Verfahren nach Anspruch 1 oder 2, bei dem die funktionelle Gruppe eine Methylgruppe, eine Isopropylgruppe, eine Tert-Butylgruppe, eine Methoxymethylgruppe, eine Isopropoxymethylgruppe, eine Tetrahydropyranylgruppe, eine Tetrahydrofurylgruppe, eine Trimethylsilylgruppe, eine Tert-Butoxycarbonylgruppe oder eine Isopropoxycarbonylgruppe ist.

4. Verfahren nach Anspruch 1, 2 oder 3, bei dem die funktionelle Gruppe eine Tert-Butoxycarbonylgruppe ist.

5. Verfahren nach Anspruch 1, bei dem der Kunststoff (a) sich wiederholende Einheiten der folgenden Formel aufweist: 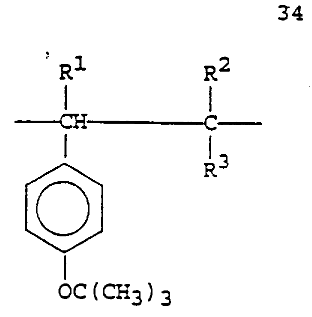 wobei R¹, R und R³ unabhängig voneinander ein Wasserstoffatom, ein Halogenatom oder eine niedrige Alkylgruppe sind sowie weitere Grundeinheiten mit einer eine verbesserte Wärmebeständigkeit hervorbringenden Gruppe, wobei diese Gruppe eine Imidogruppe, eine Amidogruppe, eine Phenylgruppe, eine Hydroxyphenylgruppe, eine Chlorophenylgruppe und/oder eine Cyanogruppe ist.

6. Verfahren nach Anspruch 1 oder 2, bei dem der Kunststoff sich wiederholende Einheiten der folgenden Formel aufweist: 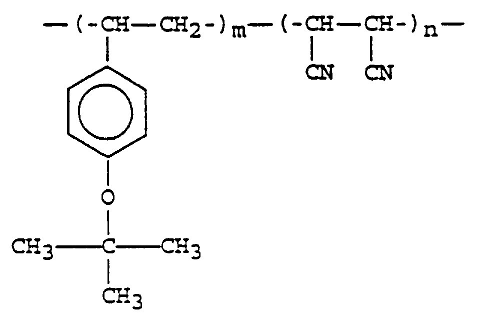 wobei gilt m:n = 1:1 bis 3:1.

7. Verfahren nach Anspruch 1 oder 2, bei dem Kunststoff sich wiederholende Einheiten der folgenden Formel aufweist: 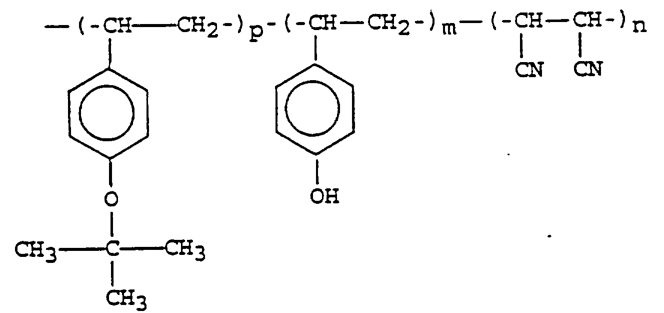 wobei gilt: p:m:n = 1:1:1.

## Revendications

1. Procédé de formation d'un motif, comprenant les opérations consistant
à former, sur un substrat, un film d'une matière formatrice de motif qui comprend
(a) une résine comportant des groupements fonctionnels qui sont susceptibles d'être solubles dans les bases sous atmosphère acide et une partie qui présente une résistance à la chaleur,
(b) un composé photosensible susceptible de donner naissance à un acide par exposition à la lumière, et choisi dans le groupe constitué par 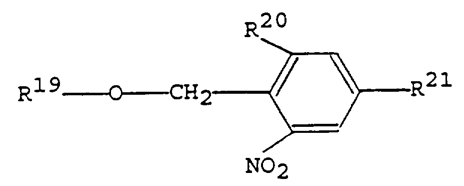 où R¹⁹ est un groupement trichloroacétyle, un groupement p-toluènesulfonyle, un groupement p-trifluorométhylbenzènesulfonyle, un groupement méthanesulfonyle ou un groupement trifluorométhanesulfonyle; et R⁰ et R¹ représentent chacun, indépendamment l'un de l'autre, un atome d'hydrogène, un atome d'halogène ou un groupement nitro, 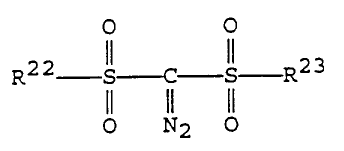 où R et R³ représentent chacun, indépendamment l'un de l'autre, un groupement alkyle en chaîne droite, ramifié ou cyclique, un groupement halogénoalkyle ou un groupement de formule 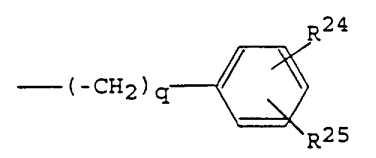 dans laquelle q est mis pour 0 ou pour un nombre entier égal à 1 ou plus; R⁴ et R⁵ représentent chacun, indépendamment l'un de l'autre, un atome d'hydrogène, un atome d'halogène, un groupement alkyle en chaîne droite, ramifié ou cyclique, un groupement halogénoalkyle, un groupement alcoxy, un groupement nitro ou un groupement cyano, 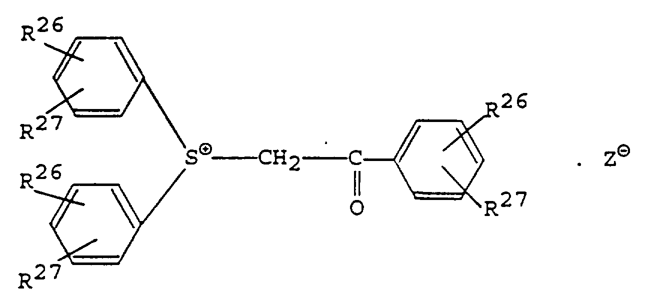 où R⁶ et R⁷ représentent chacun, indépendamment l'un de l'autre, un atome d'hydrogène, un atome d'halogène, un groupement alkyle en chaîne droite, ramifié ou cyclique ou un groupement alcoxy; et Z^{⊖} est un ion perchlorate, un ion toluènesulfonate ou un ion trifluorométhanesulfonate, 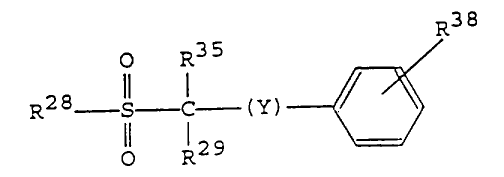 où Y est un groupement carbonyle, un groupement sulfonyle ou un groupement sulfinyle; R⁸ est un groupement alkyle inférieur, un groupement trifluorométhyle, un groupement phényle ou un groupement phényle alkyl-substitué; R⁹ et R³⁵ représentent chacun, indépendamment l'un de l'autre, un groupement alkyle inférieur, un atome d'halogène ou un atome d'hydrogène; et R³⁸ est un atome d'hydrogène, un atome d'halogène, un groupement alkyle inférieur, un groupement alcoxy ou un groupement alkylthio, et 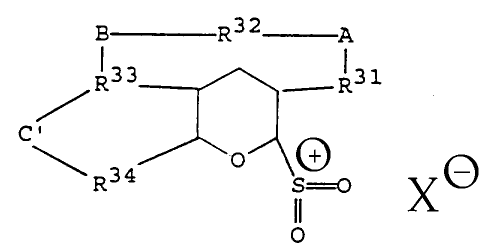 où X^{⊖} est un contre-ion; R³¹, R³, R³³ et R³⁴ représentent chacun, indépendamment les uns des autres, un atome d'hydrogène, un atome d'halogène, un groupement alkyle en chaîne droite, ramifié ou cyclique, un groupement halogénoalkyle, un groupement alcoxy, un groupement aralkyle, un groupement phényle substitué, un groupement phényle, un groupement nitro ou un groupement cyano; et R³¹-R³, R³-R³³ et R³³-R³⁴ forment indépendamment un noyau aliphatique, un noyau hétéroaliphatique, un noyau aromatique ou un noyau hétéroaromatique avec A, B et C' respectivement, comportant chacun 5 à 8 atomes de carbone, et (c) un solvant pour dissoudre les deux composants (a) et (b),
à exposer sélectivement le film à la lumière ultraviolette lointaine,
à chauffer le film exposé et
à développer le film résultant en utilisant un révélateur alcalin, pour former le motif désiré.

2. Procédé selon la revendication 1, dans lequel la résine (a) est obtenue par copolymérisation
(i) de styrène sur lequel sont substitués des groupements fonctionnels susceptibles d'être rendus solubles dans les bases sous atmosphère acide, et
(ii) d'un monomère comportant un groupement qui présente une résistance élevée à la chaleur et qui est choisi dans le groupe constitué par les groupements phényle non substitués, hydroxyphényle, chlorophényle, cyano, imido et amido.

3. Procédé selon la revendication 1 ou 2, dans lequel le groupement fonctionnel est un groupement méthyle, un groupement isopropyle, un groupement tert.-butyle, un groupement méthoxyméthyle, un groupement isopropoxyméthyle, un groupement tétrahydropyrannyle, un groupement tétrahydrofuryle, un groupement triméthylsilyle, un groupement tert.-butoxycarbonyle ou un groupement isopropoxycarbonyle.

4. Procédé selon l'une quelconque des revendications 1 à 3, dans lequel le groupement fonctionnel est un groupement tert.-butoxycarbonyle.

5. Procédé selon la revendication 1, dans lequel la resine (a) comporte les motifs répétitifs de formule 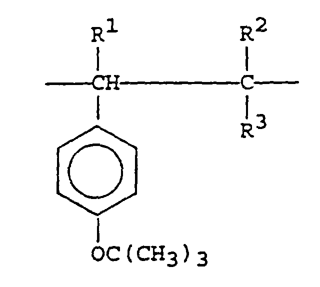 dans laquelle R¹, R et R³ représentent chacun, indépendamment les uns des autres, un atome d'hydrogène, un atome d'halogène ou un groupement alkyle inférieur, et en outre des motifs de squelette qui renferment un groupement donnant une résistance à la chaleur améliorée, ledit groupement étant au moins l'un parmi un groupement imido, un groupement amido, un groupement phényle, un groupement hydroxyphényle, un groupement chlorophényle ou un groupement cyano.

6. Procédé selon la revendication 1 ou 2, dans lequel la résine comporte des motifs répétitifs de formule 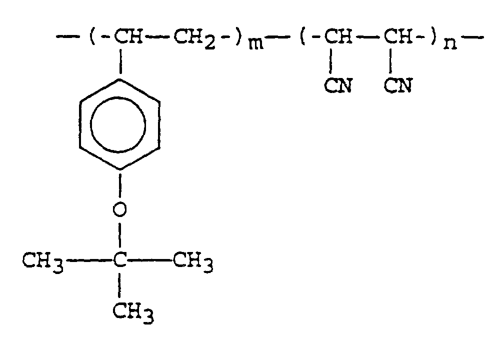 dans laquelle m:n est compris entre 1:1 et 3:1.

7. Procédé selon la revendication 1 ou 2, dans lequel la résine comporte des motifs répétitifs de formule 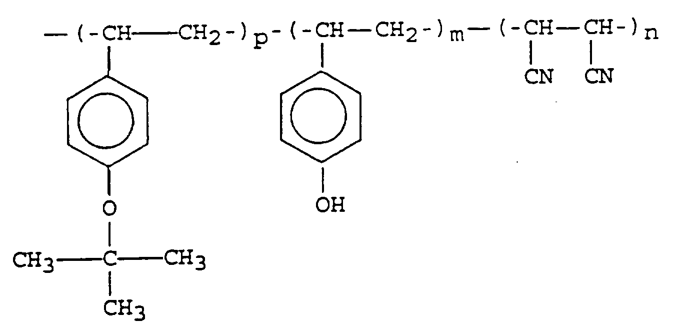 dans laquelle p:m:n est égal à 1:1:1.
